# EUROPEAN PATENT APPLICATION

(11) **EP 4 661 627 A1**
(43) Date of publication of application: **10.12.2025**
(21) Application number: 25180907.5
(22) Date of filing: 04.06.2025
(51) Int. Cl.: H10D 89/60, H02H 9/04

(54) **CLAMPING ARRANGEMENTS AND CLAMPING CIRCUITS**

(30) Priority: 07.06.2024 CN 202410740840
(71) Applicant: NXP B.V., 5656 AG Eindhoven (NL)
(72) Inventor: De RAAD, Gijs Jan, 5656 AG Eindhoven (NL); YU, Mohan, 5656 AG Eindhoven (NL); TANG, Shenglan, 5656 AG Eindhoven (NL); YU, Junfei, 5656 AG Eindhoven (NL); YU, Jiafei, 5656 AG Eindhoven (NL); ARBESS, Houssam, 5656 AG Eindhoven (NL)
(74) Representative: Hardingham, Christopher Mark

(57) **Abstract**

Disclosed is a clamping arrangement, comprising: a clamp circuit, arranged between an internal supply voltage supply rail (Vcc) and a second supply voltage supply rail (Vss) and configured to, on detection of a high-voltage ESD event at an external terminal, protect a protected circuit from the ESD high-voltage for a duration defined by an RC-timer; and an RC-interruption circuit configured to suspend the operation of the RC-timer and thereby extend the duration, wherein the RC-interruption circuit comprises; a detector configured to detect that a voltage at an input to the protected circuit is above a reference voltage, and a switch configured to provide a current path between a mid-node of the RC-timer and a one of the second voltage supply rail and the internal supply voltage supply rail, in response to the detector detecting that the voltage at the input to the protected circuit is above the reference voltage.

## Description

### FIELD OF THE DISCLOSURE

The present disclosure relates to electrostatic discharge (ESD) protection and specifically to clamping arrangements and clamping circuits configured to limit the voltage excursions resulting from ESD events by dissipating current.

### BACKGROUND

Clamping circuits are well known and widely used to protect semiconductor devices against ESD events. A typical clamping circuit is arranged between a externally connected voltage supply rail, and a second voltage supply rail which may typically be a ground voltage supply rail. The circuit is located close to an external terminal on the first voltage supply rail and an external terminal on the second voltage supply rail, and is designed to, on the occurrence of an ESD event, allow current to flow through the clamping circuit from the first supply rail to the second voltage supply rail (typically ground). Typically a high current flow is required to be enabled quickly, but for a limited duration, in order to dissipate the energy from the ESD event without a significant increase in the voltage on the first voltage supply rail, which could otherwise result in damaging currents through other circuitry in the semiconductor device.

In some semiconductor devices, a further supply voltage may be generated from the externally connected voltage. For example, in a device having an external 5V supply, it may be convenient to generate an internal voltage at 1.5V to supply particular parts of the semiconductor device, which may be called protected circuits from an internal voltage supply rail. In semiconductor devices including such an internal voltage supply rail, there may be provided a clamping arrangement to protect the protected circuit against ESD events, in addition to the primary clamping circuit which protects the device against an ESD event on the external terminal. Since the internal voltage supply rail is not directly connected to an external terminal, the level of current protection required is generally less than that required for the primary clamping circuit. Thus, the clamping arrangement for the internal voltage supply rail typically is required to carry only a low current compared to the primary clamping circuit. Also, the clamping arrangement for the internal supply rail is typically only required for a comparatively short time.

In the situation that the protected circuit includes an external terminal to the outside world, and thus is potentially subjected to an ESD event directly, the clamping arrangement, which is intended for use on the internal supply, may not be adequate to dissipate the ESD energy.

### SUMMARY

According to a fist aspect of the present disclosure, there is provided a clamping arrangement, comprising: a clamp circuit comprising an RC-timer, the clamp circuit arranged between an internal voltage supply rail and a second supply voltage supply rail and configured to, on detection of a high-voltage ESD event at an external terminal, protect a protected circuit from the ESD high-voltage for a duration defined by an RC-timer; and an RC-interruption circuit configured to suspend operation of the RC-timer and thereby extend the duration, wherein the RC-interruption circuit comprises; a detector connected to an input of the protected circuit and configured to detect that a voltage thereat is above a reference voltage, and a switch configured to, in response to the detector detecting that the voltage at the input to the protected circuit is above the reference voltage, provide a current path between a mid-node of the RC-timer and a one of the second voltage supply rail and the internal supply voltage supply rail. In such a clamping arrangement, the RC-interruption circuit, which may be relatively small, and may consist of only two MOSFETs and two resistors may ensure that the clamping circuit is activated so long as an increased voltage associated with an ESD event is present at the external terminal which is typically an I/O Pad. Thereby a relatively low capacity, and small footprint, clamping circuit (which may be referred to as a "mini-clamp") may be used to protect the protected circuit, avoiding the significantly larger footprint than would otherwise be required to accommodate an ESD event such as a HBM.

In one or more embodiments, the clamping arrangement further comprises a current-limiting resistor having a first terminal connected to the external terminal, and a second terminal connected to the input of the protected circuit, to the second voltage supply rail through a first diode and to the internal voltage supply rail through a second diode. Such a current limiting resistor may operate to limit the voltage excursions on the input of the protected circuit, since during an ESD event current flowing through the resistor results in an IR drop across it.

In one or embodiments, the switch comprises a N-MOST, having a first main terminal connected to the ground rail, a second main terminal connected to the mid-node, and a control terminal connected to the detector. Whereas a P-MOST could be used, in general, this would require modification of the trigger circuit, and may not be preferred. Note that the disclosure is not limited to MOS transistors; for example, it could be implemented using bipolar transistors (PNP or NPN); these do have the drawback of using more drive current, and so FETs and in particular MOSFETs may generally be preferred.

In one or more embodiments the detector comprises a first resistor connected between a control terminal of the switch and the second voltage supply rail. Absent any other current path to the control terminal of the switch, the first resistor acts to tie the control of the switch to the second voltage supply rail.

In one or more embodiments the detector comprises a P-MOST having a gate connected to the internal voltage supply rail by a first resistor, a source connected to the external terminal by a current limiting resistor, and a drain connected to a control terminal of the switch.

In one or more other embodiments, the detector comprises an N-MOST having a drain connected to the internal voltage supply rail, a gate connected to the input of the protected circuit via a third resistor, and a source connected to a control terminal of the switch.

In one or more yet other embodiments, the detector comprises a P-MOST having a gate connected to an external voltage supply rail by a fourth resistor (668), a source connected to the external terminal, and a drain connected to a control terminal of the switch.

In one or more embodiments, the switch is a first switch, and the clamping arrangement further comprises a further switch, in parallel with the first resistor. In one or more such embodiments, the further switch comprises a PMOST, having a source terminal connected to the second voltage supply rail, a drain terminal connected to the control terminal of the switch, and a gate terminal configured to be supplied with a disable signal. Such a further switch may enable the switch to be disabled, and in consequence the interruption of the RC-timer may be disabled. This may allow, for example, the internal voltage supply rail to be disconnected from an internal supply voltage, without triggering interruption of the RC-timer.

In one or more embodiments the RC-timer comprises a timer resistor and a timer FET, arranged in series between the internal voltage supply rail and the second voltage supply rail, and with the mid-node therebetween. In one or more such embodiments, an RC time constant of the RC-timer may be a resistance of the timer resistor multiplied by a gate-capacitance of the timer FET.

In one or more embodiments the clamp circuit comprises the RC-timer, a driver-FET and a main FET. The clamping arrangement may include additional functionality. Furthermore, the RC-timer may operate as both a trigger circuit and a timer circuit.

In one or more embodiments the driver-FET is configured to be switched on, in response to an ESD event, until the mid-node of the RC-timer reaches a threshold voltage; and the main FET is configured to be switched on whenever the driver-FET is switched on. The RC-timer may thereby control the main FET, and in particular, the voltage across a capacitive element of the RC-timer (such as the gate capacitance of a FET), may be used as a control to control the driver FET and source FET, for example, by comparison of the voltage across the capacitive element with the threshold voltage.

In one or more embodiments, a source and a drain of the timer FET are connected to the second voltage supply rail, a gate of the timer FET is connected to a first terminal of the timer resistor, and a second terminal of the timer resistor is connected to the internal voltage supply rail. Typically, the voltage at the mid-node of the RC-timer increases, as charge flows through the resistor onto the gate-capacitance of the timer FET. In other embodiments, the RC-timer may be inverted such that, during the timing operation, charge flows away from the gate-capacitance of the timer FET. In such embodiments, the timer may keep the driver on until the voltage at the mid-node falls below the threshold.

In one or more embodiments the clamping arrangement may further comprise: a third diode connected between the external terminal and the second voltage supply rail; a fourth diode connected between the external terminal and the or an external voltage supply rail, and a main clamping circuit between the external voltage supply rail and the second voltage supply rail; and the main clamping circuit may configured to carry a greater current than the clamp circuit. Typically, the main clamping circuit is larger than the clamp circuit.

In one or more embodiments the second voltage supply rail is a ground rail. In other embodiments, the second voltage supply rail may be a local ground or a local earth.

According to a second aspect of the present disclosure, there is provided a clamp circuit, arranged between an internal voltage supply rail and a second voltage supply rail and configured to, on detection of a high-voltage ESD event at an external terminal, protect a protected circuit from the ESD high-voltage for a duration; the clamp circuit comprising timer and an interruption circuit configured to interrupt the timer; wherein the RC-interruption circuit is configured to suspend operation of the RC-timer and thereby extend the duration, wherein the RC-interruption circuit;

In one or more embodiments, the interruption circuit comprises a detector connected to an input of the protected circuit and configured to detect that a voltage thereat is above a reference voltage, and a switch configured to, in response to the detector detecting that the voltage at the input to the protected circuit is above the reference voltage, provide a current path between the timer and a one of the second voltage supply rail and the internal supply voltage supply rail, to prevent operation of the timer.

In one or more such embodiments, the timer is an RC-based timer.

In one or more such embodiments, the current path is between a mid-node of the RC-timer and the one of the second voltage supply rail and the internal supply voltage supply rail.

### BRIEF DESCRIPTION OF THE DRAWINGS

Reference will now be made to the accompanying drawings, which are not necessarily drawn to scale, and wherein:
FIG. 1 shows a block diagram of part of a semiconductor device;
FIG. 2 shows a block diagram of part of a semiconductor device, in which a protected circuit or internal IP block requires to be connected to an external terminal, and thus is directly vulnerable to ESD events;
FIG. 3 an example of a clamping circuit, which is typically used for a mini-clamp - that is to say a short duration, relatively low current carrying, clamping device;
FIG. 4 illustrates a clamping arrangement according to one or more embodiments of the present disclosure;
FIG. 5 shows a clamping arrangement according to one or more embodiments of the present disclosure;
FIG. 6, this shows a clamping arrangement according to one or more other embodiments of the present disclosure;
FIG. 7 shows a clamping arrangement according to one or more further embodiments of the present disclosure; and
FIG. 8 shows a clamping arrangement according to one or more yet further embodiments of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DETAILED DESCRIPTION

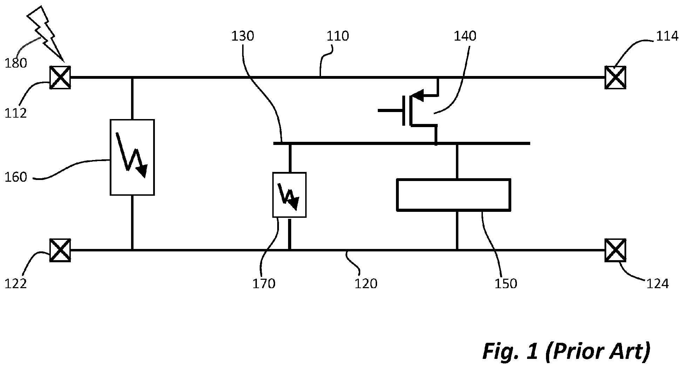

FIG. 1 shows a block diagram of part of a semiconductor device. The figure shows an external voltage supply rail 110 and a second voltage supply rail 120. As an illustrative example only, the external voltage supply rail 110 may be a 5 V rail; the second voltage supply rail 120 may be a ground rail. The external voltage supply rail 110 is connected to an external voltage supply terminal 112 and to an internal terminal 114. Internal terminal 114 is connected to circuitry within the device (not shown). The second voltage supply rail 120 is connected to a second external terminal 122, and to a second internal terminal 124. The second internal terminal 124 is connected to circuitry within the device (not shown).

The figure illustrates an internal voltage supply rail 130. The voltage on the internal voltage supply rail 130 is generated internally, from the external voltage, for example and without limitation by a regulator such as a low dropout (LDO) regulator 140. As an illustrative example only, the voltage on internal voltage supply rail 130 may be 1.5 V, since this is a particularly useful voltage to drive semiconductor devices. The internal voltage supply rail 130 provides power at the appropriate voltage such as 1.5V to circuitry 150 within the semiconductor device. The circuitry 150 may be referred to as a protected circuit, a client circuit or an internal IP block.

The figure shows a main clamping device 130, connected between the external voltage supply rail 110 and the second voltage supply rail 120 close to the terminals 112 and 122. The main clamping device may be referred to as a "railclamp" or a "bigFET". During an ESD event 180 on the external terminal 112, most of the ESD current will travel to the second terminal 122 (typically ground) through the main clamping device. However, a part of the ESD current (hereinafter referred to as a "residual" current) may travel through the regulator 140 supplying the internal voltage supply rail 130. In order to protect the protected circuit 150 from this residual current, a further clamping arrangement 170 is provided between the internal voltage supply rail 130 and the second voltage supply rail 120. This further clamping arrangement 170 may also be referred to as a "mini-clamp".

Compared with the main ESD current pulse, the residual ESD current pulse that travels via the regulator 140 and mini-clamp 170 to the second voltage supply rail (typically ground) is much smaller (i.e. the peak current is lower), and is shorter (i.e. it lasts for less time). As an example, for a typical human body model (HBM) 2kV ESD event, the main ESD current pulse may have a peak current of 1.3 amp and last, including its exponentially decreasing tail down to 5%, approximately 500 ns, since for a typical 150ns RC time constant, it will take 500 ns for the peak to decay to 5%. In contrast, the residual current pulse may have a peak current of 100 mA or less and may have a duration of 10 ns or less. Mini-clamps may therefore be designed so as to absorb these low-amplitude, short-duration pulses while taking up a minimum additional footprint.

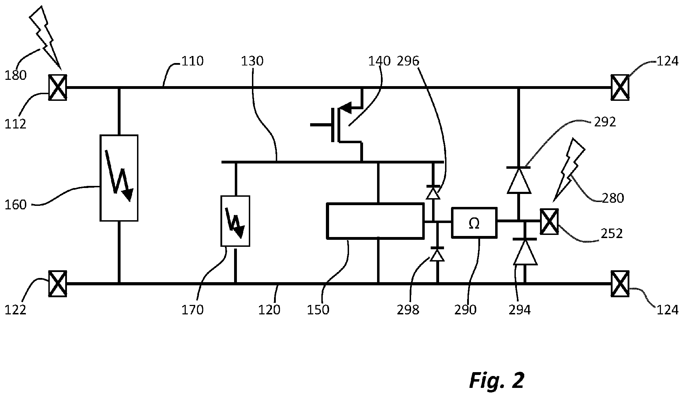

FIG. 2 shows a block diagram of part of a semiconductor device, in which the protected circuit or internal IP block 150 includes an input which requires to be connected to an external terminal 252, and thus is directly vulnerable to ESD events 280. To provide primary protection against the ESD event, the terminal may be connected to the first voltage supply rail 110 via a first diode 292, and to the second voltage supply rail 120 (typically ground) by a second diode 294. On the occurrence of an ESD event, current flows through the diode 292 and the main clamp device 160, to the second voltage supply rail 120. Furthermore, a series resistor 290, which may also be referred to as a current-limiting resistor, is placed in series between the external terminal 252 and the protected circuit 150. At the protected circuit end of the current limiting resistor 290, are a further pair of diodes 296 and 298. Diode 296 is connected between the input of the protected circuit 150 and the internal voltage supply rail 130, and the diode 298 is connected between the input of the protected circuit 150 and the second voltage supply rail 120.

The skilled person will appreciate that in an alternative arrangement, the primary protection may be provided by a grounded gate NMOST (GGNMOS) in place of the diode 294; in such a configuration, the diode 292 may not be required. Furthermore, the further pair of diodes 296 and 298 may be omitted, but this may result in an oversupply on the internal voltage supply rail, so will generally not be preferred.

In an arrangement such as that shown in FIG. 2, the protected circuit is protected from an ESD event 180 on the external voltage supply terminal 112 in the same manner as described above with respect to FIG. 1. On the occurrence of an ESD event on external terminal 252, the main ESD current flows through the main clamp 160 as mentioned above; the residual ESD current flows via the series resistor 290 and the diode 296, to the internal voltage supply rail 130. The mini-clamp 170 needs be able to sink this current; to do so, the current limiting resistor 290 and the components within the mini-clamp need to be suitably designed. However, the residual current pulse now may last as long as the main current pulse, which, as described above, is typically through diode 292 and main clamping circuit 160. In summary, whereas absence an external terminal 252, the mini-clamp170 requires only to operate for a comparatively short time such as 50 - 100 ns in order to sink pulses which typically last no more than a few nanoseconds, in the situation where the protected circuit 150 requires an external terminal, the mini-clamp requires to be able to sink current for a much longer duration, such as 500 ns or longer.

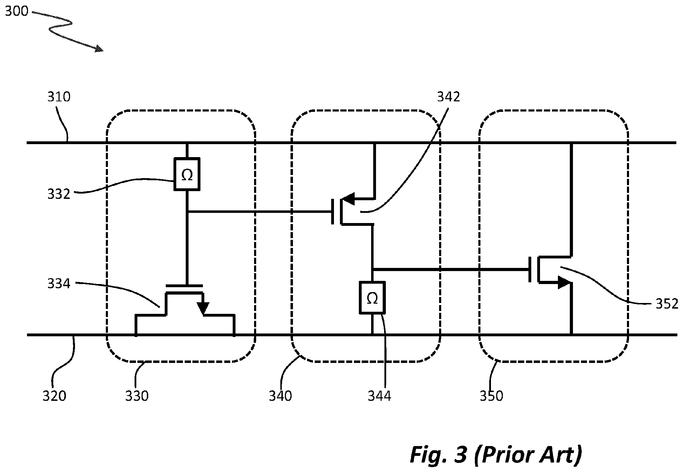

FIG. 3 an example of a clamping circuit which is typically used for a mini-clamp - that is to say a short duration (such as less than 100ns), relatively low current carrying (such as less then 500mA), clamping device. A typical clamping circuit, such as that shown, is based on an RC-timer and includes several elements. Firstly, the circuit requires a trigger circuit configured to detect the occurrence of an ESD event and specifically an overvoltage on the first supply rail 310, relative to the second supply rail 320 (which is typically ground). Secondly, the circuit requires an RC-timer. In the example shown, RC-stage 330 acts as both the RC-timer and the trigger circuit. The RC stage may, as shown comprise a timer resistor 332 and a timer FET 334, arranged in series between the first voltage supply rail 310 and the second supply rail 320, such that a source and a drain of the timer FET are connected to the second supply rail 320, the gate of the timer FET is connected to a first terminal of the resistor, and the second terminal of the timer resistor is connected to the internal voltage supply rail 310. The gate capacitance of the timer FET 334 acts as the capacitive element ("C") of the RC-timer, whilst the value of the resistor 332 provides the resistive element ("R").

Thirdly, the clamping circuit requires a high-capacity current path 350 to sink the current. Typically, this is implemented as an NMOS 352: the majority carrier in the case of an NMOS is an electron, which has a higher mobility than the holes used as majority carrier in the case of PMOS; the footprint of an NMOS device is thus smaller than a corresponding PMOS device carrying the same current. Since the NMOS device carries a large current it may be referred to as a "bigFET", or end stage. Finally, the clamping circuit typically includes a driver stage 340 which is activated by the RC stage, and drives the bigFET. The driver may comprise a PMOS 342 configured as a source follower with resistor 344 as illustrated.

As mentioned, the capacitive component of the RC stage is formed from the gate capacitor of the timer FET 334. Increasing the RC time constant, of the RC-timer, results in an increased footprint of this stage. In order to accommodate duration of 500 ns or more, the RC-timer may become comparable in size even larger than the big FET. Moreover, increasing the value of R could also result in an increased sensitivity to ripples on the internal supply line. An alternative solution in which the footprint of the mini-clamp can be reduced is thus desirable.

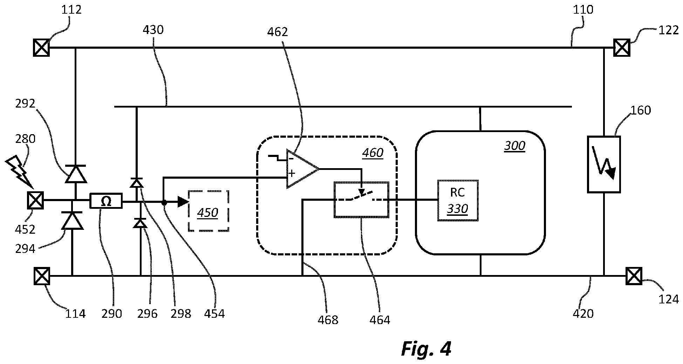

FIG. 4 illustrates a clamping arrangement according to one or more embodiments of the present disclosure. The arrangement comprises a clamp circuit 300, arranged between an internal supply voltage supply rail 430 and a second supply voltage supply rail 420. The second supply voltage supply rail may be a ground voltage supply rail. The clamp circuit is configured to, on detection of a high-voltage ESD event at an external terminal 452, protect a protected circuit 450 from the ESD high-voltage for a duration defined by an RC-timer 330. The protected circuit 450 may alternatively be described as a client circuit, or an IP block. It is not limited to a single circuit, component or IP block but may include multiple components. The RC-timer 330 may be part of an RC-stage of the clamp circuit, which may include further functionality, such as a trigger circuit. The external terminal 452 is normally a signal terminal or non-supply terminal (that is to say, generally it is not for supplying power) and so alternatively may be referred to as an IO terminal or an I/O pin. The arrangement further comprises an RC-interruption circuit 460 configured to suspend the operation of the RC-timer and thereby extend the duration. The RC-interruption circuit 460 comprises a detector 462 configured to detect that a voltage at an input to the protected circuit is above a reference voltage, and a switch 464 configured to provide a current path 468 between a mid-node of the RC-timer and a one of the ground rail 420 and the internal supply voltage supply rail 430, in response to the detector detecting that the voltage at the input to the protected circuit 450 is above the reference voltage. As shown in FIG. 4, the switch of 464 may be configured to provide a current path between the mid-node of the RC-timer and the ground rail 420. In other embodiments and as will be described in more detail hereinbelow, the switch provides a current path between the mid-node of the RC-timer 330 and the internal voltage supply rail 430. By providing the current path from the mid-node of the RC-timer 330 to the relevant voltage supply rail, the switch enables the capacitive element of the RC-timer 330 to be shorted whilst the switch is in a closed state. Closing the switch thus inhibits charge from being built up across the capacitive element of the RC-timer 330. In other words, closing the switch 464 interrupts or suspends the operation of the RC-timer 330.

As stated, the function of the detector 462 is to detect that a voltage at an input of the protected circuit 450 is above a reference voltage. The reference voltage may be related to (in particular it may be equal to) the voltage on the internal voltage supply rail 430. In other embodiments, the reference voltage may be related to, and in particular may be equal to, the voltage on another voltage supply rail. FIG. 4 shows a nonlimiting example of such another voltage supply rail, at voltage supply rail 110. As shown in figure 4, voltage supply rail 110 may be connected to an external voltage supply terminal 112, and thus may be referred to as an external voltage supply rail. The detector 462 may operate to detect the onset of an ESD event such as an ESD event 280 at the external terminal 452, by detecting that the voltage at the input to the protected circuit 450 is higher than a one of the voltage at the internal voltage supply rail 430 and the voltage at the external voltage supply rail 110, as will be described in more detail hereinbelow.

As shown in FIG. 4, the arrangement may include a current limiting resistor 290, having a first terminal connected to the external terminal 452, and a second terminal connected to the input of the protected circuit. There may be, as shown, a first diode 292 connecting the first terminal of the current limiting resistor 290 to the external voltage supply rail 110. Furthermore, there may be, as shown a second diode 294 connecting the first terminal of the current limiting resistor 290 to the second voltage supply rail 420. The arrangement may include a main clamping circuit 160 between the external voltage supply rail 110 and the second voltage supply rail 420. The function of such a clamping circuit 160 is to provide protection against an ESD event at the external voltage supply terminal 112. It also provides a primary clamping function and a main current path in the event of a an ESD event at the external terminal 452. In other embodiments this or these main clamping functions may be provided otherwise than through diode 292 and clamping circuit 160. For example, diode 294 may be replaced by a grounded gate NMOS (GGNOMS), configured to conduct current directly to the second supply rail 420 on the occurrence of an ESD event 280. In such embodiments, neither of the diodes 292 and 294 need be present and the main clamping circuit 160 is also not present.

As already mentioned, the current limiting resistor 290 has a terminal at a node 454 connected to input of the protected circuit to be protected 450. This terminal and thus the input to the protected circuit 450 is connected to the second voltage supply rail 420 by a diode 496, and to the internal voltage supply rail 430 by a diode 298. On the occurrence of an ESD event 280 at external terminal 452, current flows through the current limiting resistor 290, and the voltage at node 454 rises (though not as high as that at the external terminal 452, due to the voltage loss in the current limiting resistor 290). When the voltage on the node exceeds that of the internal voltage supply rail 430, the diode 298 starts to conduct, and provides a current path to and through the main stage of the mini-clamp 300. At the same time, once the voltage at the node exceeds the reference voltage on the detector 462 (which may be for instance connected to the internal voltage supply rail 430), the detector 462 detects the ESD event, and closes the switch 464 in order to suspend or interrupt the operation of the RC-timer 330 which is part of the mini-clamp 300. The switch 464 remains in a closed state, (that is to say, it "is closed") all while the detector 462 detects a higher voltage at node 454 than the reference voltage (which, as was stated above, may typically be the voltage on the internal supply voltage supply rail 430). The operation of the RC-timer thus remains suspended until the voltage at node 454 falls below the reference voltage (such as the voltage on the internal voltage supply rail 430). When the voltage at node 404 falls below the reference voltage, the switch opens and the RC-timer starts to operate, such that the mini-clamp continues to provide a low resistance current path between the internal voltage supply rail 430 and the second voltage supply rail 422 for, and only for, a duration determined by the RC-timer. It will be appreciated that the midpoint of the RC-timer, which is acted on by the RC-interruption circuit 460 has only a very weak connection to the power supply. The components of the RC-interruption circuit 460 therefore do not require to draw a high current and may be kept small so as to not occupy much space or "real estate" on the semiconductor chip. Typically, the RC-timer and RC-interruption circuit 460 together occupy a smaller area than does the main FET 352. Furthermore, the skilled person will appreciate that the sizes of the PMOS and NMOS transistors and of the resistors should be chosen so as to ensure that latch-up does not occur.

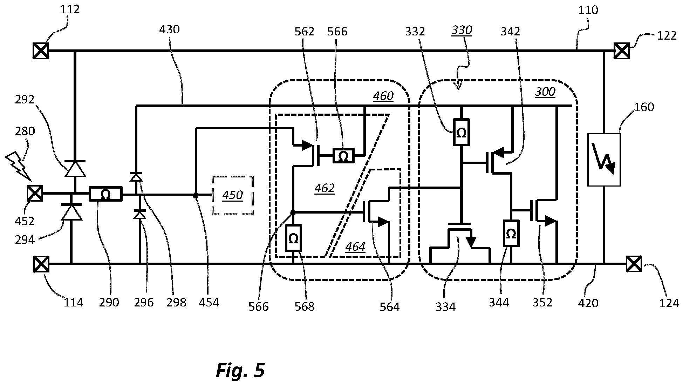

FIG. 5 shows a clamping arrangement according to one or more embodiments of the present disclosure, in more detail. The first voltage supply rail 110 and terminals 112 and 122, the second voltage supply rail 420 and terminals 114 and 124, internal voltage supply rail 430, and external terminal 452, are arranged as shown in FIG. 4 and need not be described in more detail, as are diodes 292 and 294 together with main clamping device 160, current limiting resistor 290 and diodes 296 and 298, and protected circuit 450. Node 454 between the current limiting resistor 290 and the input to the protected circuit 450 is connected to the detector circuit 462. The detector first circuit 462 comprises a PMOST 562, together with resistors 562 and 566. PMOST 562 is connected in series with the resistor 568 between the node 454 and the second voltage supply rail 420. The source of PMOST 562 is connected to the node 454, added strain connected to resistor 568. The gate of PMOST 562 is connected to the internal voltage supply rail 430 via resistor 566. Switch 464 is implemented as an NMOST 564, having its source connected to the second voltage supply rail 420, and its drain connected to the midpoint of the RC stage 330 of the clamping device or mini-clamp 300. The gate of NMOST 564 is connected to a node 566 between the resistor 568 and PMOST 562.

In normal operation, that is to say absent an ESD event 280, the voltage at the external terminal 452 and at the node 454 is lower than the voltage on the internal voltage supply rail 430, and the PMOS 562 is switched off. Node 566 is pulled to the voltage on the second voltage supply rail 420 through resistor 568, and thus the gate of NMOST 564 is low and so NMOST 564 implementing switch 464 is off.

During the initial stages of an ESD event 280 on external terminal 452, the potential of the terminal 452 rises quickly (it typically increases by 5V in less than 1 ns). A similar rise in potential is present on the node 454 and on the internal voltage supply rail 430. The increase in the internal voltage supply rail 430 triggers the clamp device 300 through the trigger circuit (which as discussed above in this instance is formed by the RC-timer circuit 330) enabling the driver PMOST 342 to open the bigFET 352. Most of the current from the ESD events 280 flows via the primary protection diode 292 and main clamping device 160; a residual ESD current flows via the current limiting resistor, the "mini-clamp" or clamping device 300, and specifically through the NMOST 352. The resulting raised voltage on the internal voltage supply rail 430 results in a current through the resistor 332 of the RC-timer 330. However, instead of this current resulting in a buildup of charge on the gate of the timer FET 334, it is conducted to ground through switch 564. The RC-timer is thus suspended or inhibiting form operating.

The clamping device 300 continues to operate for as long as there is ESD current flowing through the protection diode 298 and the clamping device 300. For a typical ESD events such as an HBM event, the duration of this ESD current may far exceed the time constant of the RC-timer 330. At some moment, the ESD current pulse ends, such that the diode 298 ceases to conduct. When this occurs, PMOST 562 switches off, and node 566 is pulled to the second supply voltage (typically ground), which in turn switches off the switch 464. Absent a path to ground, RC-timer starts and the current through RC-timer resistor 332 accumulates on the gate of the timer FET 334, resulting in an increasing voltage on the gate of the FET. At the end of the period corresponding to the RC time constant, the clamping device 300 switches off.

As mentioned above, the gate of the PMOST 562 may be connected to the internal voltage supply rail 430 through a resistor 566. This resistor is included for ESD purposes - in particular to provide protection to the gate of the PMOST 562. It typically has a value between 100 Ω several kΩ. In embodiments, a higher value, such as tens of kΩ, may be chosen for this resistor to create an RC filter with the parasitic gate capacitance of the PMOST, in order to reduce the sensitivity of the circuits to glitches on the external terminal 452.

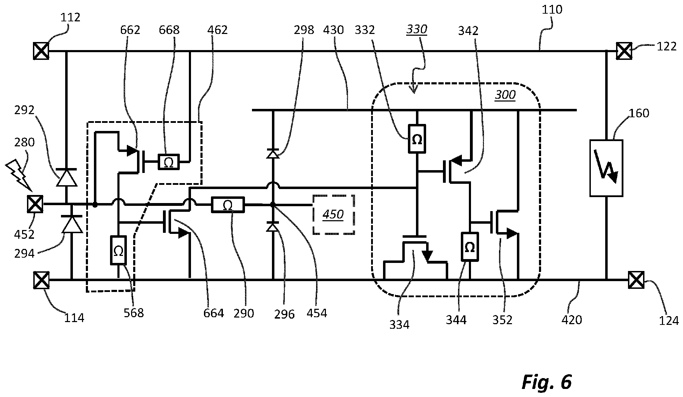

Turning now to FIG. 6, this shows a clamping arrangement according to one or more other embodiments of the present disclosure. The mini-clamp or clamping device 300 is the same as that shown in FIG. 5, as is the protected device 450, current limiting resistor 290 and diodes 296 and 298 connecting the nodes 300 between the current emitter resistor 290 and the protected circuit 450 to the internal voltage supply rail 430 and the second voltage supply rail 420 respectively. Similarly, the diodes 204 and 292 and main clamping device 160 are the same as that shown in FIG. 5. However, in embodiments such as that shown in figure 6, the detector 462 is configured to compare the voltage on the external terminal 452 with the first voltage supply rail 110. To do so, a PMOST device 662 is provided having its gate connected to the first voltage supply rail 110 through resistor 668. The source of PMOST 662 is connected to the external terminal 452, and its drain is connected to the second voltage supply rail 420 via a resistor 668. The skilled person will appreciate that for this arrangement, PMOS 662 must be able to handle a higher voltage than PMOST 552 shown in FIG. 5, since in this embodiment, the PMOST must be able to handle the voltage on the first voltage supply rail 110. Operation of the arrangement shown in FIG. 6 is similar to that shown in FIG. 5, except that the detector 462 switches on the switch 664 in response to the ESD event 280 resulting in a voltage on the external terminal 452 which exceeds that of the first voltage supply rail 110.

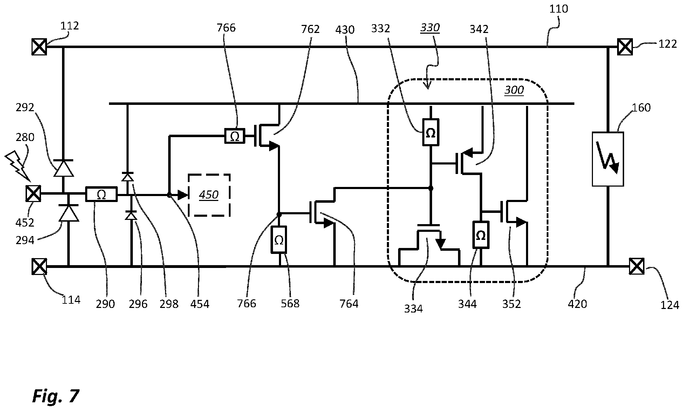

FIG. 7 shows a clamping arrangement according to one or more further embodiments of the present disclosure. As shown in FIG. 7 the PMOS 562 in the detector may be replaced by an NMOST 762, similarly configured in a source-follower mode with resistor 568 connected between the source of NMOST 762 and the second voltage supply rail 420, with the switch control terminal, that is to say the gate of PMOST 764, connected to the node 766 between the NMOST and the resistor 568. The gate of the NMOST is connected through a second current limiting resistor 766 to the node 454 between the current limiting resistor 290 and the protected circuit 450.

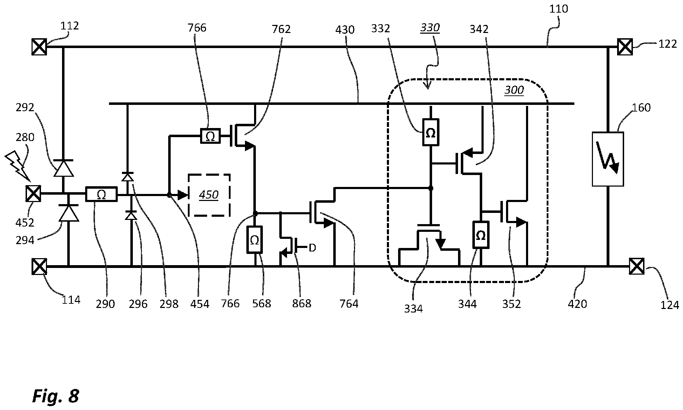

FIG. 8 shows a clamping arrangement according to one or more yet further embodiments of the present disclosure. This figure shows an arrangement which is similar to that shown in FIG. 7 except that a further NMOST 868 is provided, to enable the switch 764 to be disabled. That is to say NMOST 868 is arranged having its main terminals in parallel with the resistor 568, which may also be referred to as a grounding resistor. Applying a disable signal to its control terminal (gate in this instance) forces node 766 low and inhibits operation of the switch 764. Such a disable switch 868 may be useful in applications in which the internal voltage supply rail 430 is unpowered or switched off. In such circumstances, absent a disable switch 868 and in particular a disable signal, a "high" signal on the external terminal 452 could trigger unwanted operation of the mini-clamp or clamping device 300.

The skilled person will appreciate that the RC-interruption circuit according to the embodiments of the present disclosure will not activate the mini-clamp or clamping device 300 so long as the node at the input of the protected circuit 450 is not lifted above the reference level, which is typically the voltage at the internal voltage supply rail 430.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. Figures are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated or constructed to achieve the same or a similar purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features or aspects from one or more embodiments can be combined with one or more features or aspects of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

## Claims

1. A clamping arrangement, comprising:
a clamp circuit comprising an RC-timer, the clamp circuit arranged between an internal voltage supply rail and a second voltage supply rail and configured to, on detection of a high-voltage ESD event at an external terminal, protect a protected circuit from the ESD high-voltage for a duration defined by the RC-timer; and
an RC-interruption circuit configured to suspend operation of the RC-timer and thereby extend the duration, wherein the RC-interruption circuit comprises;
a detector connected to an input of the protected circuit and configured to detect that a voltage thereat is above a reference voltage; and
a switch configured to, in response to the detector detecting that the voltage at the input to the protected circuit is above the reference voltage, provide a current path between a mid-node of the RC-timer and a one of the second voltage supply rail and the internal supply voltage supply rail.

2. The clamping arrangement of claim 1, further comprising:
a current-limiting resistor having a first terminal connected to the external terminal, and a second terminal connected to the input of the protected circuit, to the second voltage supply rail through a first diode and to the internal voltage supply rail through a second diode.

3. The clamping arrangement of any preceding claim, wherein the switch comprises a N-MOST, having a first main terminal connected to the second voltage supply rail, a second main terminal connected to the mid-node of the RC-timer, and a control terminal connected to the detector.

4. The clamping arrangement of any preceding claim, wherein the detector comprises a first resistor connected between a control terminal of the switch and the second voltage supply rail.

5. The clamping arrangement of claim 4,
wherein the detector comprises a P-MOST having a gate connected to the internal voltage supply rail by a first resistor, a source connected to the external terminal by a current limiting resistor, and a drain connected to a control terminal of the switch.

6. The clamping arrangement of claim 4,
wherein the detector comprises an N-MOST having a drain connected to the internal voltage supply rail, a gate connected to the input of the protected circuit via a third resistor, and a source connected to a control terminal of the switch.

7. The clamping arrangement of claim 4,
wherein the detector comprises a P-MOST having a gate connected to an external voltage supply rail by a fourth resistor (668), a source connected to the external terminal, and a drain connected to a control terminal of the switch.

8. The clamping arrangement of claim 4 or any claim depending therefrom, wherein the switch is a first switch, and further comprising a further switch, in parallel with the first resistor.

9. The clamping arrangement of claim 8, wherein the further switch comprises a PMOST, having a source terminal connected to the second voltage supply rail, a drain terminal connected to the control terminal of the first switch, and a gate terminal configured to be supplied with a disable signal.

10. The clamping arrangement of any preceding claim: wherein
the RC-timer comprises a timer resistor and a timer FET, arranged in series between the internal voltage supply rail and the second voltage supply rail, and with the mid-node therebetween.

11. The clamping arrangement of claim 10,
wherein an RC time constant of the RC-timer is a resistance of the timer resistor multiplied by a gate-capacitance of the timer FET.

12. The clamping arrangement according of any preceding claim, wherein the clamp circuit comprises the RC-timer, a driver-FET and a main FET.

13. The clamping arrangement of claim 12, wherein:
the driver-FET is configured to be switched on, in response to an ESD event, until the mid-node of the RC-timer reaches a threshold voltage; and
the main FET is configured to be switched on whenever the the driver-FET is switched on.

14. The clamping arrangement of claim 13
wherein a source and a drain of the timer FET are connected to the second voltage supply rail, a gate of the timer FET is connected to a first terminal of the timer resistor, and a second terminal of the timer resistor is connected to the internal voltage supply rail.

15. The clamping arrangement of any preceding claim, further comprising:
a third diode connected between the external terminal and the second voltage supply rail;
a fourth diode connected between the external terminal and the or an external voltage supply rail, and
a main clamping circuit between the external voltage supply rail and the second voltage supply rail;
wherein the main clamping circuit is configured to carry a greater current than the clamp circuit.
